(19) Europäisches Patentamt / European Patent Office / Office européen des brevets

(11) **EP 4 568 009 A1**

(12) **EUROPEAN PATENT APPLICATION**

(43) Date of publication:
**11.06.2025 Bulletin 2025/24**

(21) Application number: **24158788.0**

(22) Date of filing: **21.02.2024**

(51) International Patent Classification (IPC):
**H01P 5/10** (2006.01)      **H01L 23/66** (2006.01)
**H01P 1/04** (2006.01)

(52) Cooperative Patent Classification (CPC):
**H01P 5/10; H01L 23/66; H01P 1/047;**
H01L 2223/6627

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH MA MD TN**

(30) Priority: **07.12.2023 EP 23386131**

(71) Applicant: **NXP B.V.
5656 AG Eindhoven (NL)**

(72) Inventors:
• **Syed, Waqas Hassan**
  **5656AG Eindhoven (NL)**
• **van Schelven, Ralph Matthijs**
  **5656AG Eindhoven (NL)**
• **Nandagopal, Harish**
  **5656AG Eindhoven (NL)**
• **Janssen, Erwin**
  **5656AG Eindhoven (NL)**
• **Doris, Konstantinos**
  **5656AG Eindhoven (NL)**

(74) Representative: **Hardingham, Christopher Mark
NXP Semiconductors
Intellectual Property Group
The Cattle Barn
Upper Ashfield Farm, Hoe Lane
Romsey, Hampshire S051 9NJ (GB)**

Remarks:
Amended claims in accordance with Rule 137(2) EPC.

(54) **A SLOT-CONFIGURATION DIE-TO-PACKAGE BALUN COUPLER**

(57) Disclosed is a packaged semiconductor device comprising a semiconductor die comprising a MMIC having a differential output; a package substrate, comprising first second and third metal layers, and electrically connected to the semiconductor die by a plurality of pillars between the semiconductor die and the first metal layer, wherein the first and third metal layers comprise a ground plane, and the second metal layer, therebetween, comprises a single-ended stripline; wherein the differential output is galvanically connected to the first metal layer by a pair of pillars aligned along a first axis; wherein the packaged semiconductor device comprises a balun coupler between the differential output, and the single-ended stripline aligned along a second axis; wherein the balun coupler comprises an opening in the first metal layer, the opening comprising two arms extending in a first direction parallel to the second axis.

FIG. 1A

EP 4 568 009 A1

**Description**

Field

The present disclosure relates to packaged millimetre or microwave frequency semiconductor devices having signal couplers between a semiconductor die and a package substrate.

Background

High performance millimetre-wave ("mm-wave") or microwave interfaces are important for maximizing the performance of the monolithic microwave integrated circuits (MMIC). A cost-effective and performance-driven packaging technique to connect the MMICs IOs to the PCB can be realized by using a ball-grid-array based (BGA) package structure. Examples of these packages are embedded wafer level ball grid array (eWLB), flip-chip chip-scale package (FCCSP) and flip-chip ball-grid array (FCBGA).

A galvanic connection from the silicon die (MMIC) to the PCB board is then obtained, which includes two intermediate transitions: firstly, a die-to-package transition, which connects the die to the package laminate metal-and-dielectric layers, or the die to a metallization layer on top of a dielectric layer. A differential implementation of the silicon circuitry is generally preferred, as this decreases the sensitivity of the active circuitry to external (common-mode) signals present, for example, on the PCB lines. And so the transition from die to package will be differential as well. The second transition is the package-to-PCB interface, which connects the package to the PCB using the (solder-ball) ball-grid array. This interface can be designed to be either differential or single-ended. In general, on the PCB it is typically preferred to work with single-ended signals to, for example, feed single-ended antennas, and because routing of single-ended transmission lines may be easier to accomplish than of balanced differential transmission lines.

In such implementations in which all mm-wave interfaces are differential at the die-to-package and at the package-to-PCB interface, an additional function to convert from balanced-to-single-ended (unbalanced) signals must be added on the PCB. This is generally called a BALUN function.

Recent efforts to reduce the PCB interconnect losses have resulted in launcher-in-package concepts, particularly in the field of mm-wave automotive radars. In this concept the mm-wave signal is launched from the package directly into a low-loss air filled waveguide using for example a patch antenna; this may avoid the use of PCB interconnects.

As mentioned, it is generally desirable to have mm-wave die-interfaces which are differential. However, the majority of the PCB antenna solutions for automotive radars are based on arrays of patches which are fed using stripline lines having characteristic impedances in the order of 50Ω. In order optimize the PCB footprint, it is preferred to have the package-ball connection single-ended thus requiring an on-die or in-package integrated BALUN. On-die BALUNs are typically high-loss because of the thickness of the metal is limited to a max of 1~2um for the conventional CMOS process and extendable to 3~4um for the relatively expensive "ultra-thick metal" (UTM) process nodes.

To reduce the area occupancy of the on-die BALUN and reduce the mm-wave losses simultaneously one can exploit the on-package thick metal available on the package such as FCCSP/FCBGA, for instance by implementing an in-package micro-strip based BALUN structure. However, such a low-loss BALUN implementation typically requires a minimum half-wavelength ("lambda/2") extra length to transform the differential signal to a grounded coplanar waveguide mode (GCPW) and also typically requires a ball pitch of at least 1.5 mm between adjacent receive (RX) and transmit (TX) channels.

A further limitation of using a micro-strip based balun is the challenge of providing a tunable impedance range to the die. This limitation is dictated by the design rules of the packaging technology (for example, line width, gap and stack height) which restricts the range of realizable impedances on the package.

Summary

According to a fist aspect of the present disclosure, there is provided A packaged semiconductor device comprising a semiconductor die comprising a monolithic microwave integrated circuit, MMIC, wherein the MMIC has a differential output; a package substrate, comprising at least a first metal layer, a second metal layer and a third metal layer, and electrically connected to the semiconductor die by a plurality of pillars between the semiconductor die and the first metal layer, wherein the first and third metal layers comprise a ground plane, and the second metal layer, therebetween, comprises a single-ended stripline; wherein the differential output is galvanically connected to the first metal layer by a pair of pillars aligned along a first axis; wherein the packaged semiconductor device comprises a balun coupler between the differential output, and the single-ended stripline aligned along a second axis; wherein the balun coupler comprises an opening in the first metal layer, the opening comprising two arms extending in a first direction parallel to the second axis. Providing the balun integrated with the coupler from die to package may be useful for space-saving, and may give good electro-static-discharge (ESD) protection, since the ground and the signal pin may be galvanically connected, by being shorted on a typically thick ground plane. In case of an ESD events the active components are protected due to this short circuit. Moreover, the configuration may provided a high common mode rejection ratio of up to 25-30 dB. Furthermore, this arrangement allows several degrees of freedom, which may be useful for example in order to be able to match to a range of impedances.

In one or more embodiments, the first axis is parallel to the second axis.

In one or more embodiments, the opening has an "H" configuration comprising the two arms, being elongate, and a bridge section therebetween. An H configuration has a high degree of symmetry which may be beneficial in allowing a broad bandwidth for which VSWR is low - under two, in particular. The high degree of symmetry may also provide particularly effective cancellation for example between the electric fields on the different arms of the "H". In turn this may result in little radiation, and effective, low loss coupling.

In one or more embodiments, the pair of pillars are located between the two elongate arms and one either side of the bridge section. The pillars may be symmetrically arranged either side of the bridge section that is to say they may be equidistant from the bridge section, and may be midway between the two elongate arms; this may enhance the symmetry of the device, leading to improved cancellation of the fields and unwanted radiation

In one or more embodiments, the packaged semiconductor device further comprises at least two ground bumps between the elongate arms and either side of the pair of pillars. This may result in improved shielding of the signal.

In one or more embodiments, the package substrate further comprises a fourth metal layer.

In one or more embodiments, the first axis is aligned orthogonal to the second axis. This may result in a device in which the incoming differential signal is propagating in the same direction as the outgoing single-ended signal

In one or more such embodiments, the two arms are a first arm and a second arm, wherein the opening further comprises third and fourth arms extending in a direction orthogonal to the first and second arms. This may result in an incomplete loop for the opening. Each of the pair of parallel arms may have oppositely directed electric fields, and this may result in cancellation, or partial cancellation, of fields.

In one or more embodiments, the opening forms an incomplete loop in which the third arm connects the first and second arm, and the fourth arm is connected to the second arm. In one or more such embodiments, the pair of pillars are located on either side of the third arm, such that a one of the pair of pillars is within the incomplete loop and another of the pair of pillars is outside the incomplete loop.

According to a further aspect of the present disclosure, the packaged semiconductor device may further comprise, or be mounted on, a printed circuit board, electrically connected to the package substrate by a ball grid array.

In one or more embodiments, the MMIC comprises a transmitter circuit for a radar device. The radar device may be an automotive radar device. However, the present disclosure is not limited to radar devices.

The MMIC, may comprise plurality of transmitter circuits for an automotive radar device.

According to a second aspect, there is provided a packaged semiconductor device comprising a semiconductor die comprising a monolithic microwave integrated circuit, MMIC, wherein the MMIC has a differential output; and a package substrate, comprising a balun coupler, and a stripline transmission line formed in a second metal layer being between a first metal layer electrically connected to the semiconductor die by a plurality of pillars and a third metal layer, wherein the first and third metal layers each comprise a reference plane; wherein the differential output is galvanically connected to the first metal layer by a pair of pillars, of the plurality of pillars, aligned along a first axis; wherein the stripline transmission line is aligned along a second axis; and wherein the balun coupler comprises an opening in the first metal layer, the opening comprising two arms extending in a first direction parallel to the second axis.

These and other aspects of the invention will be apparent from, and elucidated with reference to, the embodiments described hereinafter.

Brief description of Drawings

Embodiments will be described, by way of example only, with reference to the drawings, in which:

FIG. 1A shows, schematically, a section through of a packaged semiconductor device 100 according to embodiments of the present disclosure;
FIG. 1B shows a schematic, partial, plan view of the packaged semiconductor device of FIG. 1A;
FIG. 2A shows, schematically, a section through of a packaged semiconductor device 100 according to other embodiments of the present disclosure;
FIG. 2B shows a schematic, partial, plan view of the packaged semiconductor device of FIG. 2A;
FIG. 3 shows a metal layer (such as the first metal layer 122 on a first major surface of a package substrate) having therein a conventional "straight slot";
FIG. 4 shows a metal layer having therein an "H" configuration slot according to embodiments of the present disclosure;
FIG. 5A shows a packaged semiconductor device according to one or more embodiments;
FIG. 5B shows a model-based simulation of the device of FIG. 5A;
FIG. 6A shows, schematically, a section through of a packaged semiconductor device 100 according to other embodiments of the present disclosure;
FIG. 6B shows a model-based simulation of the device of FIG. 6A
FIG. 7A shows, schematically, a side view of a packaged semiconductor device mounted on a PCB by means of solder balls;

FIG. 7B is a plan view of the device of FIG. 7A; and

FIG. 7C is a perspective view of the device of FIG. 7A and FIG. 7B

It should be noted that the FIG.s are diagrammatic and not drawn to scale. Relative dimensions and proportions of parts of these FIG.s have been shown exaggerated or reduced in size, for the sake of clarity and convenience in the drawings. The same reference signs are generally used to refer to corresponding or similar features in modified and different embodiments

Detailed description of embodiments

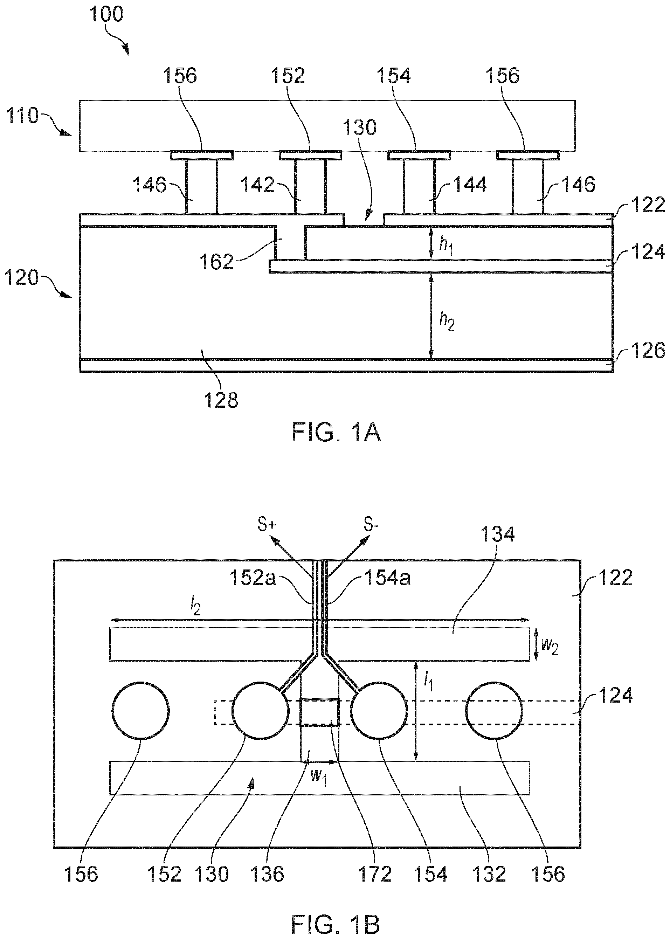

FIG. 1A shows, schematically, a section through of a packaged semiconductor device 100 according to embodiments of the present disclosure. The package semiconductor device 100 comprises a semiconductor die 110, and a package substrate 120. The semiconductor die 110 includes a MMIC thereon and therein, although this is not shown in the schematic view. The package substrate 120 may be described as being a multilayer laminate substrate. The package substrate includes at least three metal layers. A first metal layer 122 is located on a first major, or top, surface of the package substrate; a second metal layer 124 is buried within the package substrate, and a third metal layer 126 is located on a second major, or bottom, surface of the package substrate 120. The first 122 and third 126 metal layers form a ground plane for transmission of millimetre wave signals; the second metal layer is patterned to form one or more stripline transmission lines; it may include additional metal therebetween. The skilled person will appreciate that a stripline transmission line is a variant of a microstrip transmission line, in which the primary conductor or transmission line is located between two reference or ground planes separated by dielectric (whereas in a conventional microstrip transmission line, the primary conductor or transmission line is typically located on the surface, and separated from a single reference or ground plane by dielectric), A stripline may be referred to, generically, as a microstrip or microstrip transmission line The first metal layer includes an opening or slot 130 therein as will be discussed in more detail hereinbelow. The opening is generally completely surrounded by metal, and thus may be considered to be "finite" The metal layers are separated by dielectric layers formed of insulating material 128 which comprises low-loss dielectric, as will be familiar to the skilled person. Package substrate 120 supports functions including signal power distribution, heat dissipation, and protection, . In some applications, for example in FCCSP arrangements, the semiconductor die 110 is connected to the package substrate 120 through a matrix of solder balls or pillars, which may alternatively be described as "bumps", or "C4s" (controlled collapse chip connections"), typically formed from copper. FIG. 1A shows two example groups of pillars. A first group comprises a pair of pillars being a first pillar 142 and a second pillar 144. The pillars are connected to the MMIC circuit in the semiconductor die 110 by metal tracks or traces 152a, 154a carrying high frequency that is to say millimetre wave or microwave signals. Shown in the FIG. are the pair of signal tracks 152a and 154a which carry between them a differential, or balanced, millimetre wave signal, to contact pads 152, 154, which are connected to respective pillars 142 and 144. Also shown are a second group of pillars 146. These may generally referred to as ground pillars, and are connected to metal regions 156 on the semiconductor die which are grounded. The pillars may be arranged in a regular or irregular array, as will be exemplified in more detail hereinbelow. In general, there may be more ground pillars than differential signal pillars, although only two ground pillars are shown in FIG. 1A, for the purposes of illustration.

As shown in FIG. 1A, galvanic connection may be provided between the first metal layer 122 and the second metal layer which comprises the stripline transmission lines 124, the galvanic connection is typically provided by means of vertical shorting via formed of a metal such as copper. The example shown in FIG. 1 A, includes one such via 162, located at the end of the stripline transmission line.

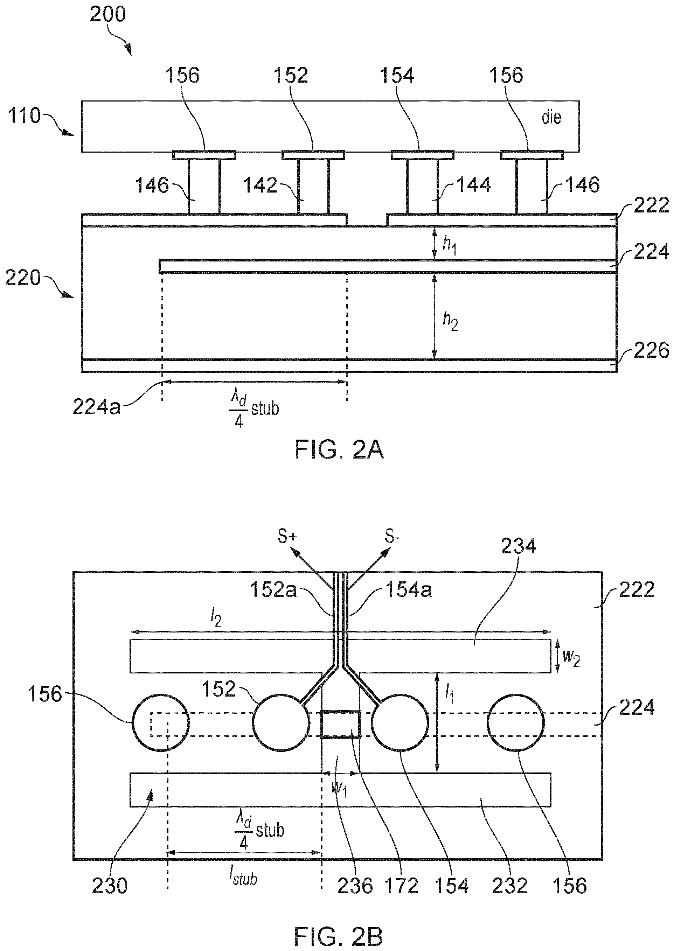

FIG. 1B shows a schematic, partial, plan view of the packaged semiconductor device of FIG. 1A. In particular, the semiconductor die 110 and the MMIC circuit thereon are not shown except for the differential metal tracks or traces 152a and 154b which , in use, carry the differential signal S+ and S- to the contact pads 152 and 154 which are connected to for the differential signal pillars 142 and 144, and the pair of contact pads 156 for the ground pillars 146. FIG. 1B shows the first metal layer 122, having the opening or slot 130 therein. The opening or slot comprises two arms 132 and 134 extending in a first direction which is parallel to an axis between the differential signal pillars 142 and 144. In the embodiment depicted in FIG. 1, the opening slot 130 has the geometrical form of an "H", in which the two arms are elongate, and are connected by a bridge region 136. Also shown in FIG. 1B is the stripline transmission line 124. In the embodiment shown, the stripline transmission line is parallel to the elongate arms of the "H" configuration of the opening or slot 130. Note that in the schematic view, shown in this FIG. (and FIG. 2B), the dielectric is hidden, so the stripline 172 is visible through the slot. As can be seen from FIG. 1B and FIG. 1A, the arrangement of the slot in the first metal layer at the surface of the package substrate 120 acts as a balun in that it converts the differential, that is to say, balanced, signal on lines or tracks 152a and 154a, to a single-ended, that is to say unbalanced, signal on stripline transmission line 124. The slot thus acts as balun coupler in that it both couples the signal from the semiconductor die 110 to the package substrate 120 and converts the signal from differential to single-ended.

The embodiment depicted in FIG. 1A and FIG. 1B includes galvanic coupling to the stripline transmission line through the suitably positioned via 162. FIG. 2A and FIG. 2B show alternative embodiments according to the present disclosure, in which the coupling is non-galvanic. FIG. 2a and FIG. 2B are generally similar to FIG. 1A and FIG. 1B respectively, and depict a package semiconductor device 200 comprising a semiconductor die 110 having signal contact pads 152 and 154 connecting to signal tracks 152a and 154a, and ground pads 156. The signal contact pads 152 and 154, and ground pad 156, are connected to a package substrate 220 by means of metal pillars 142 and 144, and 146 respectively. The package substrate 220 includes a first metal layer 222 on its first major surface, a second metal layer comprising stripline transmission lines 224 within its body, and a third metal layer 226 on its second major surface. In this embodiment, the opening or slot 230 takes the geometrical form of an "H" having first 232 and second 234 elongate arms connected by a bridge section 236. However, in this embodiment there is no via 162 connected in the first metal layer to the stripline transmission line 224. That is to say there is no galvanic connection between the first and second metal layers forming closed-circuit coupling. Instead, the end of the transmission line is extended away from the slot by a distance of approximately "one quarter wavelength", that is to say $\lambda/4$, to form an open-circuited stub 224a, as will be familiar to the skilled person.

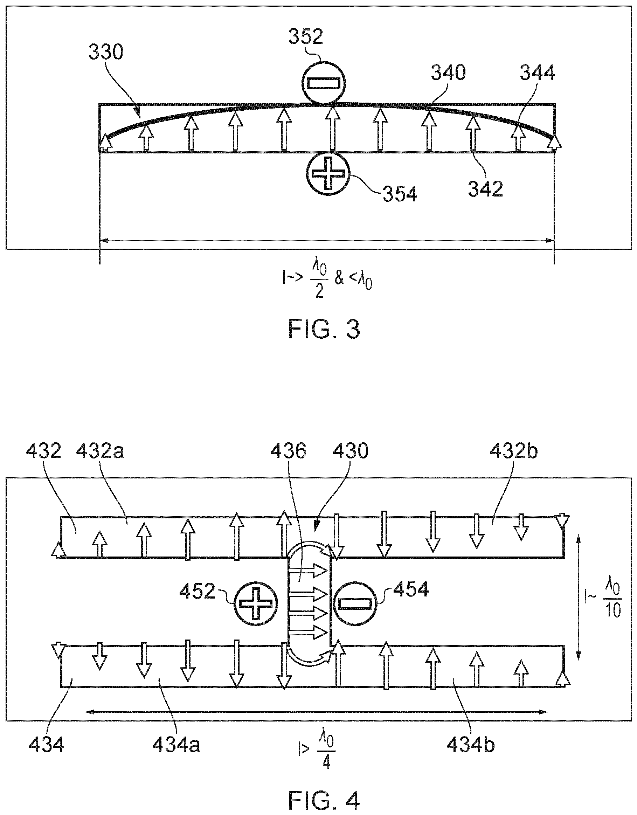

Turning now to FIG. 3, this shows a metal layer (such as the first metal layer 122 on a first major surface of a package substrate) having therein a conventional "straight slot" 330, fed by feed points 352 and 354, such as the pillars 142 and 144. The slot has a length l which is between about half lambda and lambda, where lambda is the wavelength of the signal, that is to say,

$$\lambda/2 < l < \lambda.$$ The width of the slot is small compared to the wavelength, typically, $$w < \lambda/20,$$ and is thus typically of the order of $50\mu m$. A conventional straight slot can be used as an antenna in many applications due to the nature of the in-phase electric field (E-field) distribution 340, which is depicted as the envelope of individual the field vectors 342, 344 etc. on the left and right arm of the slots as shown in FIG. 3. In particular, the conventional straight slot is an effective antenna for radiating the signal (both in and out of the paper as shown, and also along the ground plane, up and down as shown).

Turning now to FIG. 4, this shows a metal layer having therein an "H" configuration slot 430 according to embodiments of the present disclosure. The slot 430 comprises first elongate arm 432 having a left branch 432a and a right branch 432b, and second elongate arm 434 having a left branch 434a and a right branch 434b. The elongate arms are connected by a bridge section 436. Feed points 452 and 454 are located adjacent, or proximate, to and on either side of the bridge section 436. The elongate arms are separated by a relatively small distance $$l \sim \lambda_0/10$$ compared with the wavelength of the signal, and the length of each of the elongate arms is at least one quarter of the target wavelength $\lambda_0$, that is to say $$l > \lambda_0/4.$$ The E-field lines bend to follow the slot geometry (that is to say, they point away from the positive feed-point 452 and towards the negative feed point 454) such that that the two sides (left and right) are excited 180° out of phase, thereby supressing or even cancelling any radiation from each arm. Further suppression of radiation is achieved due to the 180° phase difference between the top and bottom slot sections. This may result in higher isolation between the neighbouring channels, which may or may not also consist of slot geometry, and lower losses.

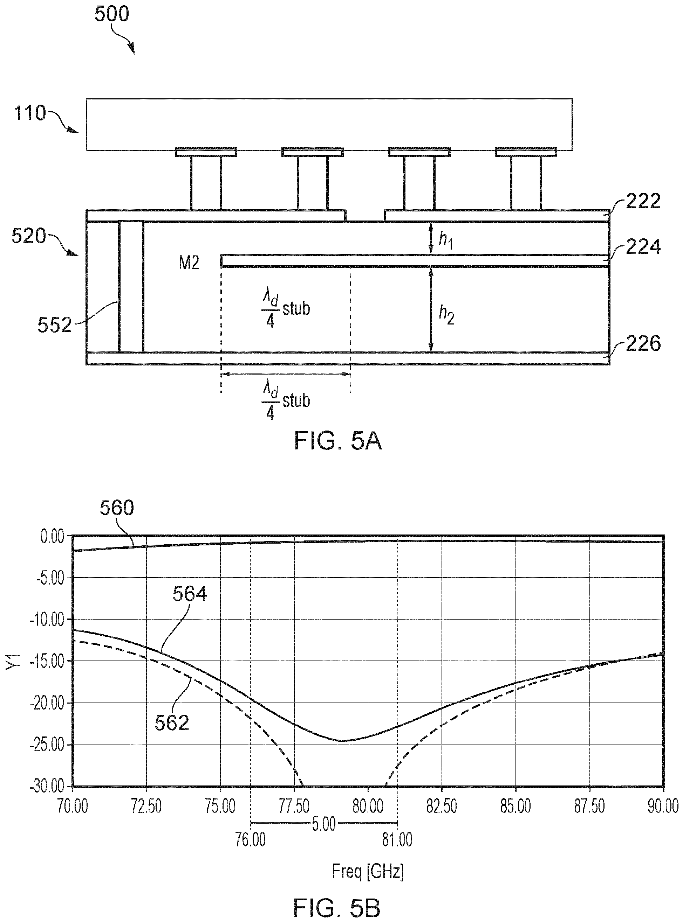

FIG. 5A shows a packaged semiconductor device 500 according to one or more embodiments. The device 500 is similar to that shown in FIG. 2 discussed above, and comprises a semiconductor die 110 and a package substrate 520. The packaged substrate is arranged with a quarter lambda stub to provide open circuit, non-galvanic, coupling into the stripline transmission line 224 in the package substrate 520. The first and third metal layers 222 and 226 are electrically coupled together by a so-called "via fence". A via fence is a plurality of vias directly coupling the first and third metal layers 222 and 226. For the purpose of clarity, shown in the FIG. is only a single via 552. The via fence may be arranged with vias substantially surrounding the end portion and in particular the start of the stripline transition line.

FIG. 5B shows a model-based simulation of the electromagnetic (EM) insertion loss at 560, and the return losses at the die (at plot 562) and at the stripline (at plot 564) at the reference planes close to the transition, plotted against frequency over a 70 to 90 GHz frequency range. With reference to FIG. 2B, The slot dimensions used in the for simulations were in ranges of 100-250$\mu m$ for $l_1$, 1000-1500 $\mu m$ for $l_2$, 50-75$\mu$ for both $w_1$ and $w_2$, the stripline width was in a range of 50-75$\mu m$ and an open stub length between 250 and 300$\mu m$. As is evident from the FIG. and the above-mentioned impedance values, besides performing a compact die-to-package transition and a balun function, the transition also allows for an impedance transformation over the die-to-package interface.

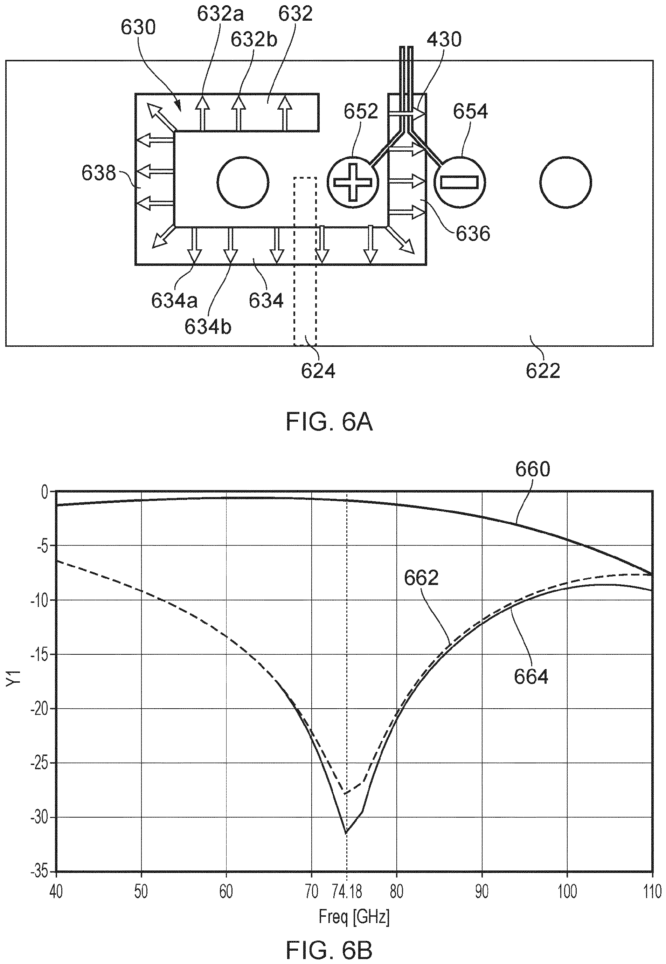

The geometrical configuration of the slot depicted in FIG. 1B includes a high degree of symmetry, and thus is particularly effective at providing low loss coupling and avoiding parasitic radiation into neighbouring channels. However, other geometrical configurations of the slot are also possible. FIG. 6A shows one such geometrical configuration. The FIG. depicts, similar to FIG. 2A, a partial plan view of a packaged semiconductor device in which a first metal layer 622 on the top surface of a package substrate includes an opening or slot 630. Two feed points 652 and 654 provide a differential feed to the opening or slot 630. The opening or slot 630 comprises two arms 632 and 634 extending in a first direction parallel to an axis joining the two feed points 652 and 654. In the embodiment shown, the opening or slot 630 includes two additional arms 636 and 638 which are generally orthogonal to arms 632 and 634. The arms are arranged to form a continuously connected slot, with generally right-angled corners between arms 636 and 634, between arms 634 and 638, and between arms 638 and 632. The feed points are located one either side of one of the arms, in this case arm 636. The stripline transmission line 624 is shown, and in this embodiment, it extends in a direction which is orthogonal to the axis joining the feed points. Since the differential signal on the semiconductor die is generally routed to the feed points in a direction orthogonal to the axis joining the feed points, this embodiment results in a single-ended or unbalanced transmission line in the package substrate which is aligned to - that it is to say it has an axis parallel to - the direction of the tracks supplying the signal to the feed points. This is in contrast to the embodiment shown in FIG. 1B and FIG. 2B in which the stripline transmission line is parallel to the axis joining the feed points and thus generally orthogonal to the direction of the tracks supplying the signal to the feed point. In other words, in the embodiments shown in FIG. 1B and FIG.2B, the signal undergoes a 90° or right angle turn within the balun coupler, whereas in the embodiment shown in FIG. 6A the signal continues in the same general direction as it is coupled from its differential form in the semiconductor die to its single-ended form in the stripline transmission line in the package substrate.

Generally, the total length of the opening or strip slot may be around one-half lambda that is to say half the wavelength of the signal which is coupled. The phase difference between the signal in the pair of opposing arms 634 and 632 is thus generally less than 90° and, as can be seen from electric field lines 632a, 632b,..., and 634a, 634b.. The fields in the two arms tend to cancel each other to suppress radiation. Similarly, the phase difference between the signal in the pair of opposing arms 636 and 638 is generally less than 90° and the electric field in the two arms tend to cancel each other to suppress radiation. Of course, the skilled person will appreciate that, due to the lower symmetry of the embodiment shown in this FIG. relative to that shown in FIG. 1B and FIG. 2B, radiation suppression and cancellation in opposing arms is generally more effective and more complete in the "H" configuration than the embodiment shown in FIG. 6A.

FIG. 6B shows model-based simulations of the electromagnetic (EM) insertion loss, for the configuration shown in FIG. 6A at 660, and the return losses at the die (at plot 662) and at the stripline (at plot 664) at the reference planes close to the transition, plotted against frequency over a 70 to 90 GHz frequency range. Comparing this FIG. with the plots of FIG. 5B, it is apparent that the embodiment shown in FIG. 6A results in an increase in the insertion loss as the frequency moves away from the design frequency, together with higher return losses, compared with the "H" configuration. On the other hand, being able to route the single-ended stripline transmission line in the same direction as the differential signal may result in a more compact device design for some applications.

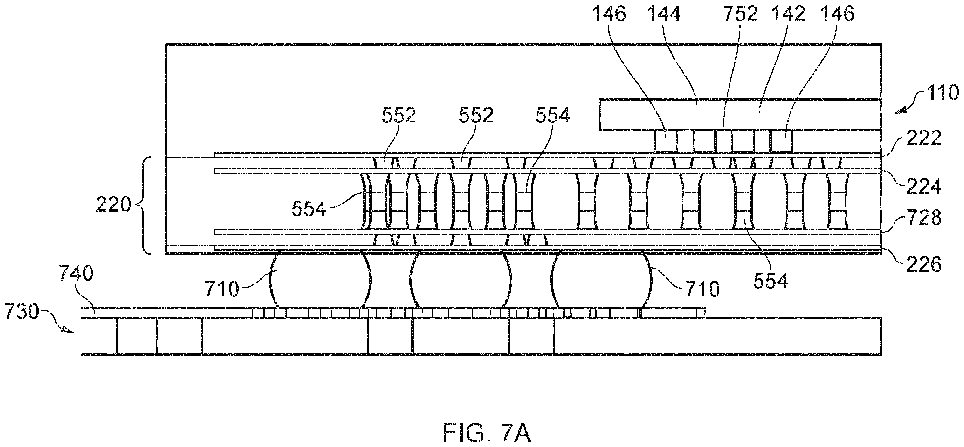

FIG. 7A shows, schematically a side view of a packaged semiconductor device 100 mounted on a circuit board or PCB 730 by means of solder balls 710. The packaged semiconductor device 100 comprises a semiconductor die 110 and a package substrate 220. The semiconductor die 110 is electrically connected to the package substrate 220 by means of pillars such as solder pillars which include ground pillars 146, and a pair of differential signal pillars 142 and 144. As described above, the pillars 142 and 144 are positioned either side of a bridge section 236 of an opening or slot 230 which has two elongate arms 232 and 234, in a first metal layer 222 at the first, or top, surface of the package substrate 220. Also as described above, the package substrate 220 includes a third metal layer 226 on its second major, or bottom, surface. The slot operates as a balun coupler to a stripline transmission line comprised in the second metal layer 224 within the package substrate 220. FIG. 7A also shows a fourth metal layer 728, also within the package substrate 220, which is connected to parts of the second metal layer, which parts which do not form the stripline transmission line, by a plurality of electrically conductive vias 554. (it should be noted that, the fourth metal layer may alternatively be referred to as M3, counting from the top of the substrate, and the third metal layer as M4). The skilled person will appreciate that the non-signal parts of the second metal, as well as the other metal layers, will generally all be ground, to assist in isolation. Furthermore, although only four metal layers are shown in this figure, the substrate may include more metal layers interleaved between, and/or surrounding the low-loss dielectric.

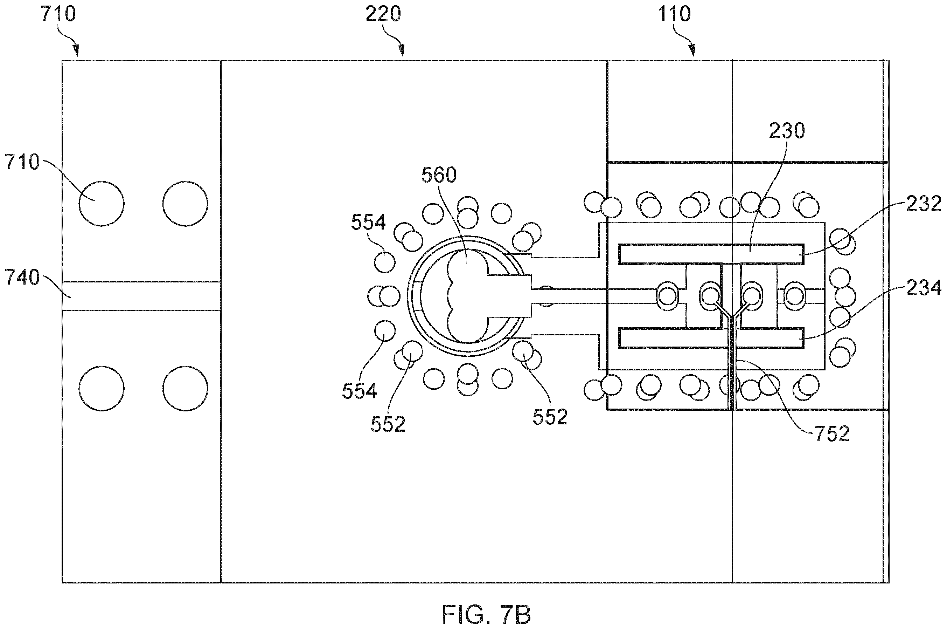

FIG. 7B shows schematically, a plan view of the device 100 of FIG. 7A mounted on the circuit board 730. The "fence" of the grounding vias 552 around the stripline transmission line 224 is clearly apparent in this view, as is the configuration of the opening or slot in the first metal layer 222 which forms the balun coupler. As can be seen, the electrically conductive vias 554 connecting the parts of the second and fourth metal layers other than the stripline transition line are also arranged in a fence configuration, which acts as an outer shielding of the coax. Providing such a via fence and connecting the vias emulates a waveguide with a much higher cut-off frequency, which helps to restrict any losses due to the radiation int the substrate. The FIG. also shows a coaxial connection 560 within the package which is used to route the signal from the stripline in the second metal layer through the fourth metal layer (728) to the third metal layer 226 (at the bottom of the package). The signal is transferred to the PCB by means of a signal ball (not visible) which is under the coax and is surrounded by the solder balls 710 and which are grounded and thus provided additional shielding.

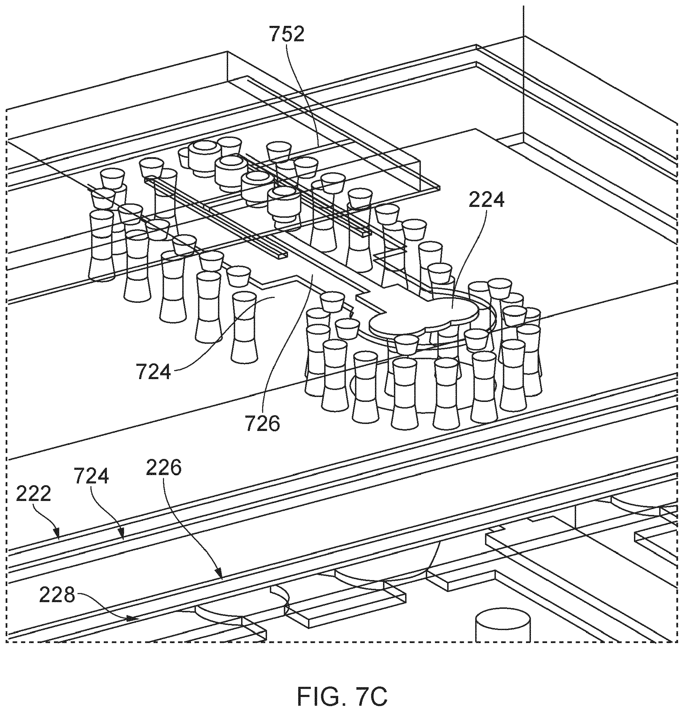

FIG. 7C shows a perspective view of the device 100 and circuit board 730 shown in FIG. 7A and FIG. 7B. The differential signal lines on the die are shown as 752. The vias 552 and 554 which form the fences are more clearly visible. It is also more clearly apparent that the stripline transmission line 224 is separated from other metal regions 724 within the same metal layer by a gap 726.

From reading the present disclosure, other variations and modifications will be apparent to the skilled person. Such variations and modifications may involve equivalent and other features which are already known in the art of MMIC couplers, and which may be used instead of, or in addition to, features already described herein.

Although the appended claims are directed to particular combinations of features, it should be understood that the scope of the disclosure of the present invention also includes any novel feature or any novel combination of features disclosed herein either explicitly or implicitly or any generalisation thereof, whether or not it relates to the same invention as presently claimed in any claim and whether or not it mitigates any or all of the same technical problems as does the present invention.

It is noted that one or more embodiments above have been described with reference to different subject-matters. In particular, some embodiments may have been described with reference to method-type claims whereas other embodiments may have been described with reference to apparatus-type claims. However, a person skilled in the art will gather from the above that, unless otherwise indicated, in addition to any combination of features belonging to one type of subject-matter also any combination of features relating to different subject-matters, in particular a combination of features of the method-type claims and features of the apparatus-type claims, is considered to be disclosed with this document.

Features which are described in the context of separate embodiments may also be provided in combination in a single embodiment. Conversely, various features which are, for brevity, described in the context of a single embodiment, may also be provided separately or in any suitable sub-combination.

For the sake of completeness it is also stated that the term "comprising" does not exclude other elements or steps, the term "a" or "an" does not exclude a plurality, a single processor or other unit may fulfil the functions of several means recited in the claims [delete if not relevant] and reference signs in the claims shall not be construed as limiting the scope of the claims. Furthermore, the word "may" is used in a permissive sense (i.e., meaning having the potential to), rather than the mandatory sense (i.e., meaning must). Similarly, the words "include," "including," and "includes" mean including, but not limited to.

## Claims

1.    A packaged semiconductor device comprising

a semiconductor die comprising a monolithic microwave integrated circuit, MMIC, wherein the MMIC has a differential output;
a package substrate, comprising at least a first metal layer, a second metal layer and a third metal layer, and electrically connected to the semiconductor die by a plurality of pillars between the semiconductor die and the first metal layer, wherein the first and third metal layers comprise a ground plane, and the second metal layer, therebetween, comprises a single-ended stripline;
wherein the differential output is galvanically connected to the first metal layer by a pair of pillars, of the plurality of pillars, aligned along a first axis;
wherein the packaged semiconductor device comprises a balun coupler between the differential output, and the single-ended stripline aligned along a second axis; and
wherein the balun coupler comprises an opening in the first metal layer, the opening comprising two arms extending in a first direction parallel to the second axis.

2.    The packaged semiconductor device according to claim 1,
wherein the first axis is parallel to the second axis.

3.    The packaged semiconductor device according to claim 2,
wherein the opening has an "H" configuration comprising the two arms, being elongate, and a bridge section therebetween.

4.    The packaged semiconductor device according to claim 3,
wherein the pair of pillars are located between the two elongate arms and one on either side of the bridge section.

5.    The packaged semiconductor device according to claim 4,
wherein the pair of pillars are located midway between the two elongate arms.

6.    The packaged semiconductor device according to claim 4 or 5,
wherein the pair of pillars are located equidistant from the bridge section.

7. The packaged semiconductor device according to any of claims 4 to 6, further comprising at least two ground pillars between the elongate arms and either side of the pair of pillars.

8. The packaged semiconductor device according to any preceding claim, wherein the package substrate further comprises a fourth metal layer.

9. The packaged semiconductor device according to claim 1, wherein the first axis is aligned orthogonal to the second axis.

10. The packaged semiconductor device according to claim 9, wherein the two arms are a first arm and a second arm, wherein the opening further comprises third and fourth arms extending in a direction orthogonal to the first and second arms.

11. The packaged semiconductor device according to claim 10, wherein the opening forms an incomplete loop in which the third arm connects the first and second arm, and the fourth arm is connected to the second arm.

12. The packaged semiconductor device according to claim 11, wherein the pair of bumps are located on either side of the third arm, such that a one of the pair of pillars is within the incomplete loop and an other of the pair of pillars is outside the incomplete loop.

13. The packaged semiconductor device according to any preceding claim, further comprising a printed circuit board, electrically connected to the package substrate by a ball grid array.

14. The packaged semiconductor device according to any preceding claim, wherein the MMIC comprising a transmitter circuit for a radar device.

15. The packaged semiconductor device according to claim 14, wherein the radar device is an automotive radar device.

**Amended claims in accordance with Rule 137(2) EPC.**

1. A packaged semiconductor device (100) comprising

   a semiconductor die (110) comprising a monolithic microwave integrated circuit, MMIC, wherein the MMIC has a differential output; a package substrate (120), comprising at least a first metal layer (122), a second metal layer (124) and a third metal layer (126), and electrically connected to the semiconductor die by a plurality of pillars (142, 144, 146) between the semiconductor die and the first metal layer, wherein the first and third metal layers comprise a ground plane, and the second metal layer, therebetween, comprises a single-ended stripline (124); wherein the differential output is galvanically connected to the first metal layer by a pair of pillars (142, 144), of the plurality of pillars, aligned along a first axis; wherein the packaged semiconductor device comprises a balun coupler between the differential output, and the single-ended stripline aligned along a second axis; and wherein the balun coupler comprises an opening in the first metal layer, the opening comprising two arms (132, 134) extending in a first direction parallel to the second axis.

2. The packaged semiconductor device according to claim 1, wherein the first axis is parallel to the second axis.

3. The packaged semiconductor device according to claim 2, wherein the opening has an "H" configuration comprising the two arms, being elongate, and a bridge section (136) therebetween.

4. The packaged semiconductor device according to claim 3, wherein the pair of pillars are located between the two elongate arms and one on either side of the bridge section.

5. The packaged semiconductor device according to claim 4, wherein the pair of pillars are located midway between the two elongate arms.

6. The packaged semiconductor device according to claim 4 or 5, wherein the pair of pillars are located equidistant from the bridge section.

7. The packaged semiconductor device according to any of claims 4 to 6,
further comprising at least two ground pillars (146) between the elongate arms and either side of the pair of pillars.

8. The packaged semiconductor device according to any preceding claim,
wherein the package substrate further comprises a fourth metal layer (728).

9. The packaged semiconductor device according to claim 1,
wherein the first axis is aligned orthogonal to the second axis.

10. The packaged semiconductor device according to claim 9, wherein the two arms are a first arm (632) and a second arm (634),
wherein the opening further comprises third (638) and fourth arms (636) extending in a direction orthogonal to the first and second arms.

11. The packaged semiconductor device according to claim 10,
wherein the opening forms an incomplete loop in which the third arm connects the first and second arm (636), and the fourth arm (638) is connected to the second arm.

12. The packaged semiconductor device according to claim 11,
wherein the pair of pillars are located on either side of the fourth arm (636), such that a one of the pair of pillars is within the incomplete loop and an other of the pair of pillars is outside the incomplete loop.

13. The packaged semiconductor device according to any preceding claim,
further comprising a printed circuit board (730), electrically connected to the package substrate by a ball grid array (710).

14. The packaged semiconductor device according to any preceding claim,
wherein the MMIC comprises a transmitter circuit for a radar device.

15. An automotive radar device comprising the packaged semiconductor device according to claim 14.

**FIG. 1A**

**FIG. 1B**

FIG. 2A

FIG. 2B

FIG. 3

FIG. 4

FIG. 5A

FIG. 5B

FIG. 6A

FIG. 6B

FIG. 7A

EP 4 568 009 A1

FIG. 7B

EP 4 568 009 A1

FIG. 7C

European Patent Office
Europäisches Patentamt
European Patent Office
Office européen des brevets

# EUROPEAN SEARCH REPORT

**Application Number**

EP 24 15 8788

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | US 2022/328432 A1 (SYED WAQAS HASSAN [NL] ET AL) 13 October 2022 (2022-10-13) * paragraph [0013] - paragraph [0020] * * paragraph [0024] - paragraph [0030] * * figures 1-4 * | 1-15 | INV. H01P5/10 H01L23/66 H01P1/04 |
| A | US 2011/316642 A1 (SHIMAKAWA JUNYA [JP]) 29 December 2011 (2011-12-29) * paragraph [0025] - paragraph [0052] * * figures 1-3 * | 1-15 | |
| A | WO 2022/122114 A1 (ERICSSON TELEFON AB L M [SE]) 16 June 2022 (2022-06-16) * page 6, line 9 - page 8, line 19 * * figures 1-3 * * page 10, lines 5-28 * * figures 9-10 * | 1-15 | |
| A | WU PENG ET AL: "A wideband microstrip balun structure", 2014 IEEE MTT-S INTERNATIONAL MICROWAVE SYMPOSIUM (IMS2014), IEEE, 1 June 2014 (2014-06-01), pages 1-3, XP032615359, DOI: 10.1109/MWSYM.2014.6848433 [retrieved on 2014-07-02] * sec. II; page 1 - page 2 * * figure 1 * | 1-15 | **TECHNICAL FIELDS SEARCHED (IPC)** H01P H01L |

The present search report has been drawn up for all claims

| Place of search | Date of completion of the search | Examiner |
|---|---|---|
| The Hague | 3 July 2024 | Culhaoglu, Ali |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 24 15 8788

This annex lists the patent family members relating to the patent documents cited in the above-mentioned European search report.
The members are as contained in the European Patent Office EDP file on
The European Patent Office is in no way liable for these particulars which are merely given for the purpose of information.

03-07-2024

| Patent document cited in search report | Publication date | Patent family member(s) | Publication date |
|---|---|---|---|
| US 2022328432 A1 | 13-10-2022 | EP 4071807 A1 | 12-10-2022 |
| | | US 2022328432 A1 | 13-10-2022 |
| US 2011316642 A1 | 29-12-2011 | CN 102437435 A | 02-05-2012 |
| | | JP 5170174 B2 | 27-03-2013 |
| | | JP 2012010224 A | 12-01-2012 |
| | | US 2011316642 A1 | 29-12-2011 |
| WO 2022122114 A1 | 16-06-2022 | EP 4256649 A1 | 11-10-2023 |
| | | US 2024079754 A1 | 07-03-2024 |
| | | WO 2022122114 A1 | 16-06-2022 |

EPO FORM P0459

For more details about this annex : see Official Journal of the European Patent Office, No. 12/82